# EUROPÄISCHE PATENTANMELDUNG

(11) **EP 2 120 523 A2**
(43) Veröffentlichungstag der Anmeldung: **18.11.2009**
(21) Anmeldenummer: 09005017.0
(22) Anmeldetag: 04.04.2009
(51) Int. Cl.: H05K 7/14

(54) **Anordnung mit einem Hauptträger und einer Leiterplatte mit Bauelementen**

(30) Priorität: 15.05.2008 DE 102008023714
(71) Anmelder: SEMIKRON Elektronik GmbH & Co. KG, 90431 Nürnberg (DE)
(72) Erfinder: Backhaus, Klaus, Dr., 90768 Fürth (DE)

(57) **Zusammenfassung**

Es wird ein Anordnung mit einem Hauptträger und einer Leiterplatte beschrieben. Auf der Leiterplatte sind leichte und schweren elektrischen und / oder elektronischen Bauelementen befestigt, wobei mindestens ein schweres Bauelement mechanisch fest mit dem Hauptträger und elektrisch leitend mit Leiterbahnen eines ersten Abschnitts der Leiterplatte verbunden ist. Dieser erste Abschnitt ist elektrisch leitend mit einem zweiten Abschnitt der Leiterplatte verbunden und mittels einer Entkopplungseinrichtung von dem zweiten Abschnitt der Leiterplatte bezüglich mechanischer Schwingungen entkoppelt.

## Beschreibung

Die Erfindung beschreibt eine Anordnung mit einem Hauptträger und einer mit elektrischen und elektronischen Bauelementen bestückten Leiterplatte. Derartige Anordnungen finden vielfältig Einsatz in verschiedenen elektronischen Systemen. Werden derartig Systeme beispielhaft in Fahrzeugen mit elektrischen Haupt- oder Hilfsantrieben eingesetzt sind die Anforderungen bezüglich der mechanischen Robustheit besonders hoch. Speziell wenn derartige Schaltungsanordnungen mit Bauelementen von sehr unterschiedlicher Masse bestückt sind, sind Anforderungen an die Robustheit gegenüber Schwingungen nach dem meist eingesetzten Stand der Technik schwierig zu erfüllen.

Hier und im Weiteren sollen unter "leichten" elektrischen oder elektronischen Bauelementen beispielhaft einzelne CMOS Transistoren, mit bis zu einem Watt belastbare Widerstände und weitere Bauelemente mit einer vergleichbaren Masse verstanden werden. Unter "schweren" elektrischen oder elektronischen Bauelementen sollen Bauelemente mit mindestens der einhundertfachen Masse der leichten Bauteile verstanden werden. Dies sind beispielhaft Kondensatoren, Transformatoren oder Leistungshalbleitermodule.

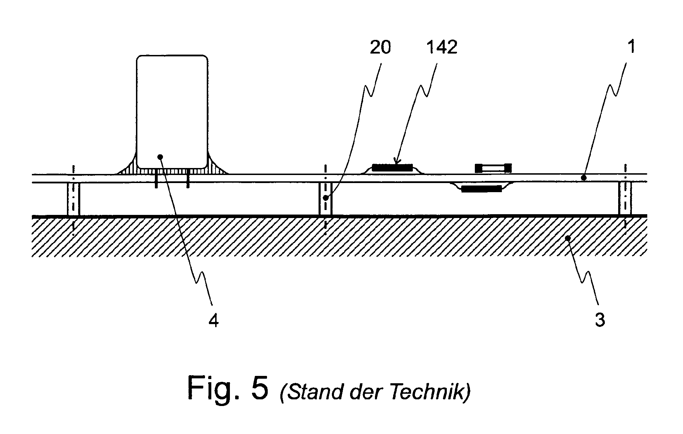

Den weit verbreiteten Stand der Technik stellt Fig. 5 dar. Hier ist mittels geeigneter Verbindungseinrichtungen (20) wie beispielhaft in Hülsen geführten Schraubverbindungen eine Leiterplatte (1) starr mit einem Hauptträger (3) verbunden dargestellt. Der Hauptträger (3) ist beispielsweise ausgebildet als ein Gehäuse aus Aluminiumdruckguss, wie es sich für die Anordnung verschiedenen Schaltungsanordnungen in Fahrzeugen besonders eignet. Dieses Gehäuse weist hierbei eine im Vergleich zur Leiterplatte (1) mit den hierauf angeordneten und schaltungsgerecht verbundenen Bauelementen (4, 142) eine wesentlich höhere Masse auf. Dieser Hauptträger (3), hier das Gehäuse selbst, ist vorzugsweise direkt und starr beispielhaft mit dem Fahrzeug verbunden.

Durch den Einfluss von Vibrationen, die mit verschiedenen Amplituden und Frequenzen sowohl parallel als auch senkrecht zur Ebene der Leiterplatte (1) auftreten können, werden vor allem die Befestigungen, in der Regel Lötverbindungen, der schweren Bauelemente (4) belastet. Beispielhaft für schwere Bauelemente (4) ist hier ein Kondensator dargestellt, der mittels einer Lötverbindung mit der Leiterplatte (3), bzw. den dortigen Leiterbahnen, verbunden ist. Zur stabileren Befestigung ist hier dargestellt und allgemein bekannt eine zusätzliche Klebeverbindung zwischen dem Kondensator (4) und der Leiterplatte (1).

Trotz dieser zusätzlichen Klebeverbindung erweist sich die Befestigung des schweren Bauelements als nicht ausreichend für, beispielhaft in Fahrzeugen, auftretende Vibrationen, wobei durch die Vibrationen die elektrisch leitende Verbindung zwischen dem schweren Bauteil und den Leiterbahnen der Leiterplatte beschädigt werden. Dies liegt ursächlich daran, dass hier der schwere Verbindungspartner an den leichten angebunden ist und somit auf Grund der Massenträgheit die Lötverbindung entsprechend stark belastet wird.

Der Erfindung liegt die Aufgabe zugrunde eine Anordnung anzugeben, wobei eine dauerhaft sichere elektrisch leitende Verbindung schwerer Bauelemente mit einer Leiterplatte ausgebildet wird, die auch unter mechanische Belastungen, wie Vibrationen, erhalten bleibt.

Diese Aufgabe wird erfindungsgemäß gelöst, durch eine Anordnung mit den Merkmalen des Anspruchs 1. Bevorzugte Ausführungsformen sind in den abhängigen Ansprüchen beschrieben.

Ausgangspunkt der erfindungsgemäßen Anordnung ist eine Anordnung mit einem Hauptträger und einer Leiterplatte mit hierauf befestigten leichten und schweren elektrischen und / oder elektronischen Bauelementen, wie sie bevorzugt in Fahrzeugen mit elektrischen Hilfs- oder Hauptantrieben verwendet wird. Hierbei ist erfindungsgemäß mindestens ein schweres Bauelement mechanisch fest mit dem Hauptträger verbunden, wobei für die Verbindungen alle bekannten Verbindungstechniken, die kraft-, form- oder stoffschlüssige Verbindungen ausbilden, geeignet sind. Hierbei ist es vorteilhaft, wenn das schwere Bauteil eine höhere Masse aufweist als der erste Abschnitt der Leiterplatte.

Weiterhin ist das schwere Bauelement elektrisch leitend mit Leiterbahnen eines ersten Abschnitts der Leiterplatte verbunden, wobei dieser erste Abschnitt elektrisch leitend mit einem zweiten Abschnitt der Leiterplatte verbunden ist. Zwischen dem ersten und dem zweiten Abschnitt der Leiterplatte ist eine Entkoppelungseinrichtung vorgesehen, die die beiden Abschnitte der Leiterplatte bezüglich mechanischer Schwingungen entkoppelt, so dass die beiden Abschnitte bei Schwingungseintrag in die Anordnung in den durch die Entkoppelungseinrichtung gegeben Grenzen unabhängig voneinander Schwingung unterschiedlicher Amplitude, Frequenzen und Schwingungsrichtung ausführen können.

Besonders bevorzugte Weiterbildungen dieser Schaltungsanordnung sind in der jeweiligen Beschreibung der Ausführungsbeispiele genannt. Die erfinderische Lösung wird zudem an Hand der Ausführungsbeispiele der Fig. 1 bis 4 weiter erläutert.

Fig. 1 zeigt einen Ausschnitt einer ersten Ausgestaltung der erfindungsgemäßen Anordnung.

Fig. 2 zeigt einen Ausschnitt einer zweiten Ausgestaltung der erfindungsgemäßen Anordnung.

Fig. 3 zeigt einen Ausschnitt einer dritten Ausgestaltung der erfindungsgemäßen Anordnung.

Fig. 4 zeigt einen Ausschnitt einer vierten Ausgestaltung der erfindungsgemäßen Anordnung.

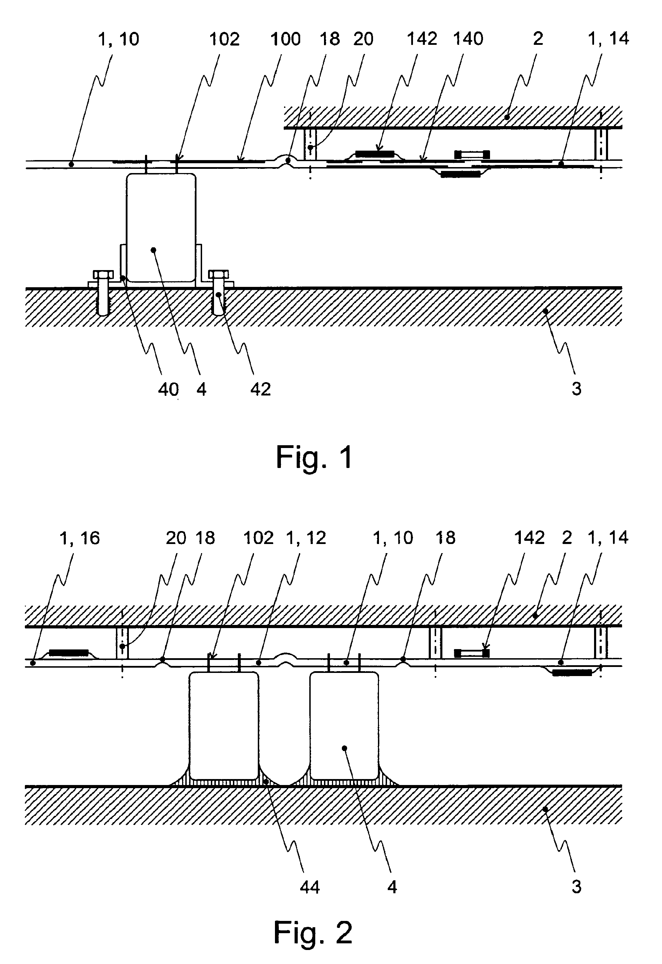

Fig. 1 zeigt einen Ausschnitt einer ersten Ausgestaltung der erfindungsgemäßen Anordnung. Dargestellt ist hier eine Leiterplatte (1), die aus zwei Abschnitten (10, 14) aufgebaut ist. An einem ersten Abschnitt (10) ist ein schweres Bauelement (4), hier ein Kondensator löttechnisch mit Leiterbahnen dieses ersten Abschnitts (10) der Leiterplatte (1) verbunden. Weiterhin weist der Kondensator (4) ein Einrichtung (40) zur Schraubverbindung auf und ist mittels dieser Einrichtung (40) und zwei Befestigungsschrauben (42) mit dem Hauptträger (3) kraftschlüssig verbunden. Diese Verbindung ist starr ausgebildet und koppelt den Kondensator (4) schwingungstechnisch an den Hauptträger (3). Auftretende Schwingungen der gesamten Anordnung belasten somit vornehmlich die starre, also mechanisch robuste, Verbindung zwischen Kondensator (4), dem schwerem Bauelement, und dem Hauptträger (3), wobei diese besonders stabil verglichen mit einer Lötverbindung ausgebildet ist. Zudem wir hier die Verbindung des Kondensators (4), mittels seiner Kontaktelemente (102) zu Leiterbahnen (100) des ersten Abschnitts (10) der Leiterplatte (1) belastet, da dieser erste Abschnitt (10) durch die von außen einwirkende Schwingung ebenfalls angeregt wird. Allerdings ist diese Belastung wesentlich geringer verglichen mit der Belastung nach dem Stand der Technik, da hier der leichtere Verbindungspartner, der erste Abschnitt (10) der Leiterplatte (1) an den schweren (4), den Kondensator, angebunden ist.

Auf einem zweiten Abschnitt (14) sind ausschließlich weitere leichte Bauelemente (142) ebenfalls mittels Lötverbindungen auf dortigen Leiterbahnen (140) angeordnet. Beispielhaft dargestellte Bauelemente (142) sind hier integrierte Schaltungen in DIP-Gehäusen sowie ein SMD- Widerstand.

Dieser zweite Abschnitt (14) der Leiterplatte (1) ist mit den bekannten Verbindungseinrichtungen (20) mit einem Hilfsträger (2) verbunden. Die bekannten Verbindungseinrichtungen (20) sind hier wiederum Schraubverbindungen mit jeweils einer Abstandshülse. Der Hilfsträger (2) ist beispielhaft der Deckel eines o.g. Gehäuses. Die Verbindung des Haupt- (3) und des Hilfsträger (2) kann starr oder vorteilhafterweise in Grenzen beweglich zueinander ausgebildet sein, wobei die Amplitude dieser Beweglichkeit geringer als diejenige des ersten (10) und des zweiten (14) Abschnitts der Leiterplatte (1) zueinander sein sollte.

Oben genannte Schwingungen der gesamten Anordnung belasten hier vornehmlich die Verbindung zwischen dem zweiten Abschnitt (14) der Leiterplatte (1) und dem Hilfsträger (2). Bei dieser Belastung ist der Einfluss der leichten Bauelemente (142) durch ihre geringe Masse, und damit verbundene geringere Massenträgheit, vernachlässigbar, wodurch die Belastung auf deren eigene Befestigung auf der Leiterplatte (1) gering ist und somit derer sichere elektrische Verbindung zu den Leiterbahnen (140) dauerhaft gewährleistet ist.

Erfindungsgemäß sind beide Abschnitte (10, 14) der Leiterplatte (1) mittels einer Entkoppelungseinrichtung (18) verbunden. Diese ist hier als flexibler Abschnitt der Leiterplatte (1) ausgebildet und weist zur elektrisch leitenden Verbindung des ersten (10) und zweiten (14) Abschnitts, diese Entkoppelungseinrichtung überbrückende, Leiterbahnen auf. Mittels der Entkoppelungseinrichtung (18) ist der erste (10) vom zweiten (14) Abschnitt der Leiterplatte (1) schwingungstechnisch weitgehend entkoppelt. Diese Entkoppelung wirkt sowohl für Schwingungseinträge parallel wie auch senkrecht zur Ebene der Leiterplatte.

Die Entkoppelung trennt somit schwingungstechnisch den ersten Abschnitt (10) vom zweiten Abschnitt (14) der Leiterplatte (1), wodurch beide in den Grenzen, die durch die Entkoppelungseinrichtung (18) gegeben, sind unabhängig voneinander schwingen können. Somit belasten Schwingung der gesamten Anordnung die Lötverbindung (102) des Kondensators (4) und der Leiterplatte (1) geringer als nach dem Stand der Technik bekannt. Dies wird erzielt, da massereichere Körper, hier der Kondensator (4), fest mit dem Hauptträger (3) verbunden ist, während der im Vergleich zum Kondensator masseärmer erste Abschnitt (10) der Leiterplatte (1) relativ frei schwingen kann.

Fig. 2 zeigt eine zweite Ausgestaltung der erfindungsgemäßen Anordnung. Gleiche Gegenstände sind wie auch im Folgenden mit gleichen Bezugszeichen versehen, wobei hier und im Folgenden auf die Darstellung der Leiterbahnen (100, 140 vgl. Fig. 1) verzichtet wird. Dargestellt ist wiederum eine Leiterplatte (1), hier allerdings mit zwei zweiten Abschnitten (14, 16), mit einem dazwischen angeordneten ersten Abschnitt (10, 12), der seinerseits nochmals unterteilt ist.

Der erste Abschnitt (10, 12) mit zwei ebenfalls voneinander entkoppelten Teilabschnitten bzw. hier angeordneten Leiterbahnen weist elektrisch leitende Verbindungen zu den Kondensatoren (4) auf. Diese Ausbildung des ersten Abschnitts (10, 12) kann bevorzugt sein. Ebenso kann es bevorzugt sein eine Mehrzahl schwerer Bauelemente (4) eng benachbart auf einem ersten Abschnitt ohne voneinander entkoppelte Teilabschnitte anzuordnen. Diese Anordnung der Kondensatoren (4) ist wie beschrieben, aber nicht hierauf beschränkt, mittels einer Lötverbindung ausgebildet. Die Kondensatoren (4) selbst sind wiederum starr mit einem Hauptträger (3), allerdings hier mittels einer Klebeverbindung (44) stoffschlüssig, verbunden.

Die zweiten Abschnitte (14, 16) mit hierauf angeordneten leichten Bauelementen (142) sind mit den bekannten Verbindungseinrichtungen (20) mit einem Hilfsträger (2) verbundenen. Somit sind mittels der Entkoppelungseinrichtung (18), hier beispielhaft als eine Freisparung im Bereich des Grundmaterials der Leiterplatte (1) ausgebildet, die beiden zweiten Abschnitte (14, 16) der Leiterplatte (1) von dem ersten Abschnitt (10, 12) schwingungstechnisch entkoppelt.

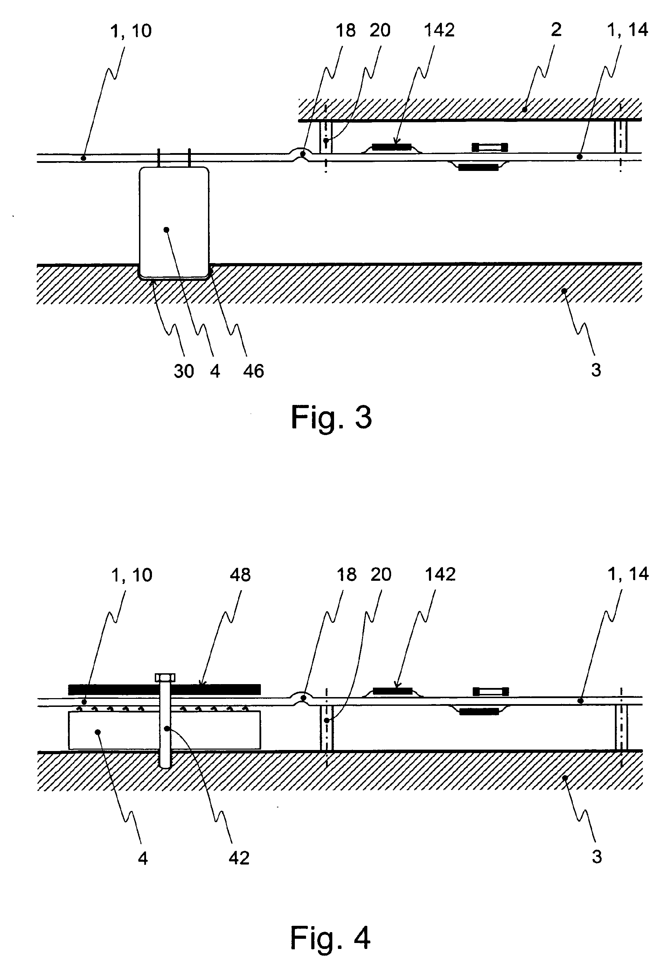

Fig. 3 zeigt einen Ausschnitt einer dritten Ausgestaltung der erfindungsgemäßen Anordnung. Diese unterscheidet sich von derjenigen gemäß Fig. 1 dadurch, dass der Kondensator (4) in eine Ausnehmung (30) des Hauptträgers (3) eingepresst ist und somit eine formschlüssige Verbindung mit diesem eingeht.

Fig. 4 zeigt einen Ausschnitt einer vierten Ausgestaltung der erfindungsgemäßen Anordnung. Diese unterscheidet sich von derjenigen gemäß Fig. 1 dadurch, dass das schwere Bauelement (4) hier ein Leistungshalbleitermodul gemäß dem Stand der Technik ist. Diese Leistungshalbleitermodul (4) weist ein Ausnehmung für die Schraubverbindung (42) zum Hauptträger (3) auf und weist zur Verbindung mit den Leiterbahnen des ersten Abschnitts (10) der Leiterplatte (1) Kontaktfedern auf, wobei die Verbindung mittels eines Druckstücks (48) und der Schraubverbindung (42) ausgebildet wird.

Weiterhin unterscheidet sich dies Ausgestaltung dahingehend, dass der zweite Abschnitt (14) der Leiterplatte (1) nicht mit einem Hilfsträger, sondern mit dem Hauptträger (3) mittels der bekannten Verbindungseinrichtungen (20) verbunden ist.

## Patentansprüche

1. Anordnung mit einem Hauptträger (3) und einer Leiterplatte (1) mit hierauf befestigten leichten (142) und schweren (4) elektrischen und / oder elektronischen Bauelementen, wobei mindestens ein schweres Bauelement (4) mechanisch fest mit dem Hauptträger (3) und elektrisch leitend mit Leiterbahnen (100) eines ersten Abschnitts (10) der Leiterplatte (1) verbunden ist, dieser erste Abschnitt (10, 12) elektrisch leitend mit einem zweiten Abschnitt (14, 16) der Leiterplatte (1) verbunden ist und mittels einer Entkopplungseinrichtung (18) von dem zweiten Abschnitt (14, 16) der Leiterplatte (1) bezüglich mechanischer Schwingungen entkoppelt ist.

2. Anordnung nach Anspruch 1
wobei das mindestens eine schweres Bauelement (4) kraft-, form- oder stoffschlüssig mit dem Hauptträger (3) verbunden ist.

3. Anordnung nach Anspruch 1
wobei die Entkopplungseinrichtung (18) als ein flexibler Abschnitt einer Leiterplatte (1) ausgebildet ist.

4. Anordnung nach Anspruch 1
wobei die Entkopplungseinrichtung (18) als eine Freisparung im Bereich des Grundmaterials der Leiterplatte (1) ausgebildet ist.

5. Anordnung nach Anspruch 1
wobei das mindestens eine schweres Bauelement (4) ein Kondensator oder ein Transformator oder ein Leistungshalbleitermodul ist.

6. Anordnung nach Anspruch 1
wobei der zweite Abschnitt (14, 16) der Leiterplatte (1) an einem Hilfsträger (2) befestigt ist und dieser mit dem Hauptträger (3) mechanisch verbunden ist.

7. Anordnung nach Anspruch 6
wobei der Haupt- (3) und der Hilfsträger (2) zueinander beweglich verbunden sind.
